# EUROPÄISCHE PATENTSCHRIFT

(11) **EP 2 310 865 B1**
(45) Veröffentlichungstag und Bekanntmachung des Hinweises auf die Patenterteilung: **22.02.2012**
(21) Anmeldenummer: 08785546.6
(22) Anmeldetag: 07.08.2008
(51) Int. Cl.: G01R 31/12, H02K 11/00

(54) **VERFAHREN ZUM ÜBERWACHEN DES BETRIEBSZUSTANDS EINER ELEKTRISCHEN MASCHINE, ANORDNUNG MIT EINER ELEKTRISCHEN MASCHINE SOWIE INFRAROT-SENSOR**
METHOD FOR MONITORING THE OPERATING STATE OF AN ELECTRIC MACHINE, ARRANGEMENT HAVING AN ELECTRIC MACHINE, AND INFRARED SENSOR
PROCÉDÉ DE SURVEILLANCE DE L ÉTAT DE FONCTIONNEMENT D UNE MACHINE ÉLECTRIQUE, DISPOSITIF AYANT UNE MACHINE ÉLECTRIQUE, ET CAPTEUR INFRAROUGE

(43) Veröffentlichungstag der Anmeldung: 20.04.2011
(73) Patentinhaber: Siemens Aktiengesellschaft, 80333 München (DE)
(72) Erfinder: VOLLMER, Rolf, 36129 Gersfeld (DE); ZETTNER, Jürgen, 90587 Veitsbronn (DE)
(86) Internationale Anmeldenummer: PCT/EP2008/006694
(87) Internationale Veröffentlichungsnummer: WO 2010/015269

(56) Entgegenhaltungen:
- WO-A-2008/044263
- KR-B1- 100 709 694
- US-A- 5 513 002
- US-A- 5 552 880

## Beschreibung

Im Rahmen des Betriebs von elektrischen Maschinen, d.h. von Elektromotoren und Generatoren, stellt die Überwachung des Betriebszustands der elektrischen Maschine eine wichtige Aufgabe dar. Ziel ist hierbei einerseits eine Überlastung der elektrischen Maschine zu vermeiden; andererseits ermöglicht das Überwachen des Betriebszustands einer elektrischen Maschine auch eine Optimierung der Auslegung der Leistungsklasse der elektrischen Maschine, so dass eine Überdimensionierung vermieden werden kann sowie eine optimale Steuerung der elektrischen Maschine und damit beispielsweise ein besonders ökonomischer oder leistungsorientierter Betrieb ermöglicht wird.

Bei elektrischen Maschinen, etwa in Form von Mittel- oder Hochspannungsmotoren, können an Stellen hohen elektrischen Feldes im luftgefüllten, metallischen Bauraum durch Ionisierung der Luft so genannte Teilentladungen auftreten. Diese können beispielsweise dadurch verursacht sein, dass es bei stark inhomogenen Feldverläufen in den verwendeten Isolierungen örtlich zur Überschreitung der materialtypischen Durchschlagfeldstärke kommt. Es tritt ein elektrischer Durchschlag auf, bei dem die Isolierung zwischen den Elektroden durch auch als äußere Teilentladungen bezeichnete Entladungen teilweise überbrückt wird.

Darüber hinaus können Teilentladungen auch in Form von äußerlich nicht sichtbaren Entladungserscheinungen innerhalb von entsprechenden Isoliermedien grundsätzlich um feste, flüssige oder gasförmige Materialien handeln.

Generell treten Teilentladungen, abkürzend häufig auch als "TE" bezeichnet, vor allem bei Beanspruchung einer Isolierung mit Wechselspannung auf. Teilentladungen können zumindest langfristig zu einer Beschädigung der elektrischen Maschine beispielsweise dahin gehend führen, dass ein zur elektrischen Isolierung verwendeter Isolierstoff beschädigt wird. Aus diesem Grund sollten Teilentladungen im Betrieb der elektrischen Maschine soweit wie möglich vermieden werden. Umgekehrt bedeutet dies, dass die Teilentladungsaktivität innerhalb einer elektrischen Maschine ein Maß für den jeweiligen Betriebszustand der elektrischen Maschine darstellt und beispielsweise eine Überlastsituation anzeigen kann. Zwar werden elektrische Maschinen zum Teil derart ausgelegt, dass Teilentladungen während des normalen Betriebs bewusst zugelassen werden; auch in diesem Fall charakterisieren auftretende Teilentladungen jedoch den aktuellen Zustand der Isolationsfestigkeit der elektrischen Maschine.

Aus US 5,513,002 ist bereits ein Verfahren zum Überwachen des Betriebszustands einer elektrischen Maschine bekannt, bei dem durch einen auf die Maschine ausgerichteten Infrarot-Sensor eine Strahlungsintensität gemessen wird und eine Kenngröße für die Teilentladungsaktivität ermittelt wird. Weiters bekannt ist Ermittlung der Temperatur der Bestandteile der elektrischen Maschine als Maß für den Betriebszustand.

Der vorliegenden Erfindung liegt die Aufgabe zugrunde, ein einfaches und zugleich besonders leistungsfähiges Verfahren zum Überwachen des Betriebszustands einer elektrischen Maschine anzugeben.

Diese Aufgabe wird erfindungsgemäß gelöst durch ein Verfahren zum Überwachen des Betriebszustands einer elektrischen Maschine, bei dem durch einen über eine Luftstrecke auf zumindest einen Bestandteil der elektrischen Maschine ausgerichteten Infrarot-Sensor selektiv in einem Wellenlängenbereich einer Absorptionsbande eines bei Teilentladungen entstehenden Ionisationsproduktes, insbesondere von bei der Ionisation von Luft entstehenden Ozons, eine Strahlungsintensität gemessen wird, aus der gemessenen Strahlungsintensität zumindest eine Kenngröße für die Teilentladungsaktivität innerhalb der elektrischen Maschine als Maß für den Betriebszustand der elektrischen Maschine ermittelt wird, die Strahlungsintensität durch den Infrarot-Sensor (10) zusätzlich in einem zweiten Wellenlängenbereich gemessen wird und aus der in dem zweiten Wellenlängenbereich gemessenen Strahlungsintensität die Temperatur des zumindest einen Bestandteils der elektrischen Maschine (1) als weiteres Maß für den Betriebszustand der elektrischen Maschine (1) ermittelt wird, wobei zum Ermitteln der zumindest einen Kenngröße für die Teilentladungsaktivität innerhalb der elektrischen Maschine (1) das Verhältnis zwischen der in dem zweiten Wellenlängenbereich gemessenen Strahlungsintensität und der in dem Wellenlängenbereich der Absorptionsbande gemessenen Strahlungsintensität gebildet wird.

Das erfindungsgemäße Verfahren weist den Vorteil auf, dass mittels eines Infrarot-Sensors eine Aussage über die Teilentladungsaktivität innerhalb der elektrischen Maschine gewonnen werden kann. Hierbei macht sich die Erfindung zu Nutze, dass bei Teilentladungen durch Ionisierung der Luft Ionisationsprodukte, wie beispielsweise Ozon oder auch Stickstoff-Sauerstoff-Verbindungen, entstehen. Neben durch Ionisierung der Luft entstehende Ionisationsprodukte können weiterhin auch solche Ionisationsprodukte verwendet werden, die in der elektrischen Maschine bei Teilentladungen, insbesondere inneren Teilentladungen, durch Ionisation verwendeter Isolierstoffe entstehen. So lassen beispielsweise die Verwendung von Glimmerbändern, Isolierbändern auf Polymerbasis, epoxidharzimprägnierten Glasfaserbändern und vorzugsweise polymerbasierten Lackierstoffen bei Teilentladungen insbesondere Kohlenwasserstoffe entstehen. Hierbei kann eine Messung der Strahlungsintensität beispielsweise im Wellenlängenbereich der C-H Absorptionsbanden bei 3,45µm beziehungsweise 7,14µm erfolgen. Die jeweilige Zusammensetzung der entstehenden Ionisationsprodukte ist dabei insbesondere von den verwendeten Isolierstoffen sowie dem Spannungsniveau der elektrischen Maschine abhängig.

Generell weist jedoch insbesondere die Verwendung von bei der Ionisation von Luft entstehenden Ozons verschiedene Vorteile auf. So tritt Ozon bei Teilentladungen üblicherweise bei allen elektrischen Maschinen auf, die an Luft betrieben werden. Darüber hinaus ist die Verwendung von Ozon auch aufgrund seiner entstehenden Menge sowie der guten Nachweisbarkeit als Ionisationsprodukt bevorzugt. Ozon weist darüber hinaus im Infrarot-Bereich mehrere Absorptionsbanden, wie beispielsweise die Hauptbande bei 9,6µm, auf. Als Absorptionsbande wird hierbei entsprechend der üblichen Definition ein Wellenlängenintervall verstanden, in dem die elektrische Strahlung einer Strahlungsquelle auf dem Weg zum Empfänger, d.h. zu dem Infrarot-Sensor, selektiv absorbiert wird. Im Rahmen des erfindungsgemäßen Verfahrens wird dabei als Strahlungsquelle der zumindest ein Bestandteil der elektrischen Maschine verwendet, auf den der Infrarot-Sensor ausgerichtet ist. Dies bedeutet, dass der zumindest eine Bestandteil der elektrischen Maschine in Abhängigkeit von seiner Temperatur Infrarot-Strahlung emittiert, d.h. abstrahlt, die von dem Infrarot-Sensor zur selektiven Messung der Absorptionsbande des Ionisationsproduktes verwendet wird. Dies bietet den Vorteil, dass zur Messung der Absorptionsbande beziehungsweise zur Bereitstellung der hierfür erforderlichen Hintergrundstrahlung keine separate Strahlungsquelle, etwa in Form eines in dem Wellenlängenbereich der Absorptionsbande abstrahlenden Emitters, benötigt wird.

Der Infrarot-Sensor kann über die Luftstrecke auf beliebige Bestandteile der elektrischen Maschine ausgerichtet werden, vorausgesetzt, diese weisen eine hinreichend hohe Temperatur auf, um Infrarot-Strahlung ausreichender Strahlungsintensität bereitzustellen. Im Betrieb einer elektrischen Maschine bieten sich als Bestandteil der elektrischen Maschine, auf den der Infrarot-Sensor ausgerichtet ist, beispielsweise der Wickelkopf, die Welle, der Rotor, der Stator oder das Gehäuse an, da diese Bestandteile üblicherweise eine ausreichend hohe Temperatur aufweisen. Dabei ist zu berücksichtigen, dass es aufgrund der metallischen Bauteile der elektrischen Maschine üblicherweise im Bereich der Luftstrecke, d.h. im Messvolumen, zu Mehrfachreflexionen der durch den zumindest einen Bestandteil der elektrischen Maschine emittierten Infrarot-Strahlung kommen wird. Dies hat den Vorteil, dass die effektive Weglänge der Infrarot-Strahlung auf dem Weg vom Ort ihres Entstehens zu dem Infrarot-Sensor vergrößert wird. Gemäß dem Lambert-Beerschen-Gesetz führt diese größere effektive Weglänge beim Durchgang durch die absorbierende Substanz, d.h. Luft, zu einer stärkeren Schwächung der Strahlungsintensität, so dass die Nachweisempfindlichkeit verbessert wird. Die durch den Infrarot-Sensor selektiv in dem Wellenlängenbereich der Absorptionsbande des bei der Ionisation von Luft entstehenden Ionisationsproduktes gemessene Strahlungsintensität ermöglicht es, zumindest eine Kenngröße für die Teilentladungsaktivität innerhalb der elektrischen Maschine als Maß für den Betriebszustand der elektrischen Maschine zu ermitteln. Dies bedeutet, dass eine Überwachung des Betriebszustands der elektrischen Maschine durch eine Überwachung der zumindest einen Kenngröße für die Teilentladungsaktivität innerhalb der elektrischen Maschine möglich ist. Vorteilhafterweise erfolgt die Überwachung erfindungsgemäß dabei auf vergleichsweise einfache und kostengünstige Art und Weise. So ist mittels des Infrarot-Sensors eine berührungslose Messung der zumindest einen Kenngröße für die Teilentladungsaktivität möglich, wobei insbesondere auf eine Strahlungsquelle in Form eines speziellen Emitters verzichtet wird. Aufgrund des indirekten Nachweises von Teilentladungen anhand des bei den Teilentladungen entstehenden Ionisationsproduktes, insbesondere Ozon, ist das erfindungsgemäße Verfahren darüber hinaus nicht nur leistungsfähig, sondern auch in den rauen Umgebungsbedingungen einer elektrischen Maschine dauerhaft und zuverlässig anwendbar.

In einer besonders bevorzugten Weiterbildung ist das erfindungsgemäße Verfahren derart ausgestaltet, dass als Kenngröße für die Teilentladungsaktivität innerhalb der elektrischen Maschine aus der gemessenen Strahlungsintensität zumindest ein die Konzentration des Ionisationsproduktes kennzeichnender Absorptionswert ermittelt wird. Da die gemessene Strahlungsintensität gemäß dem Lambert-Beerschen-Gesetz von der Konzentration des absorbierenden Stoffes, d.h. im vorliegenden Fall des Ionisationsproduktes der Luft, abhängt, stellt die gemessene Strahlungsintensität bei gleich bleibender Temperatur, d.h. bei zumindest im wesentlichen unveränderter Intensität der emittierten Strahlung, ein Maß für die Konzentration des Ionisationsproduktes dar. Anhand zumindest eines aus der gemessenen Strahlungsintensität ermittelten Absorptionswertes, d.h. beispielsweise aus dem Verhältnis der gemessenen Strahlungsintensität zu der bei einer bekannten Konzentration des Ionisationsproduktes gemessenen Strahlungsintensität, lässt sich somit die Konzentration des Ionisationsproduktes ermitteln.

In der vorliegenden Ausführungsform der Erfindung ist das erfindungsgemäße Verfahren derart ausgestaltet, dass die Strahlungsintensität durch den Infrarot-Sensor zusätzlich in einem zweiten Wellenlängenbereich gemessen wird und aus der in dem zweiten Wellenlängenbereich gemessenen Strahlungsintensität die Temperatur des zumindest einen Bestandteils der elektrischen Maschine als weiteres Maß für den Betriebszustand der elektrischen Maschine ermittelt wird. Dies bietet den Vorteil, dass mittels des Verfahrens eine Überwachung des Betriebszustands der elektrischen Maschine nicht nur hinsichtlich des Auftretens von Teilentladungen, sondern darüber hinaus auch hinsichtlich der Temperatur des zumindest einen Bestandteils der elektrischen Maschine, erfolgen kann. Dabei wird vorteilhafterweise derselbe Infrarot-Sensor verwendet, der zu diesem Zweck vorzugsweise zumindest zwei Messkanäle aufweist. Im Rahmen dieser bevorzugten Weiterbildung des erfindungsgemäßen Verfahrens wird somit die Temperatur des zumindest einen Bestandteils beziehungsweise Bauteils der elektrischen Maschine ermittelt, dessen abgestrahlte Strahlungsintensität auch bezüglich der Bestimmung der zumindest einen Kenngröße für die Teilentladungsaktivität als Hintergrundstrahler, d.h. zur Messung der Strahlungsintensität in dem Wellenlängenbereich der Absorptionsbande, verwendet wird. Eine solche Kombination einer Temperaturmessung und Gasdetektierung als Maß für den Betriebszustand der elektrischen Maschine unter Verwendung eines einzigen Infrarot-Sensors erlaubt vorteilhafterweise eine besonders genaue Aussage über den Betriebszustand der elektrischen Maschine. Darüber hinaus kann ein solches Verfahren unter Verwendung eines entsprechenden Kombinationssensors auf besonders einfache und kostengünstige Art und Weise durchgeführt werden.

Die zuletzt genannte Ausführungsform des erfindungsgemäßen Verfahrens ermöglicht es insbesondere im Falle einer Ausrichtung des Infrarot-Sensors auf den Wickelkopf der elektrischen Maschine, aufgrund der vorgenommenen berührungslosen Temperaturmessung in dem zweiten Wellenlängenbereich, auf üblicherweise im Wickelkopf von elektrischen Maschinen vergossene herkömmliche Temperatur-Sensoren, etwa in Form von Pt100-oder KTY-Sensoren, zur Bestimmung der Temperatur des Wickelkopfs zu verzichten. Entsprechende Temperatur-Sensoren weisen in der Regel vergleichsweise hohe Anteile von Vergussmassen, d.h. beispielsweise von Epoxiden und glasfasergefüllten Kunststoffen, auf, die zur elektrischen Isolation gegen die anfallenden hohen Feldstärken erforderlich sind. Ein Wegfall dieser Temperatur-Sensoren, der durch die bevorzugte Weiterbildung des erfindungsgemäßen Verfahrens grundsätzlich ermöglicht wird, führt zu Materialeinsparungen, wodurch aufgrund der mit dem Wegfall einhergehenden Reduzierung der Anteile der thermisch trägen Massen im Wickelkopf die Temperaturableitung in diesem Bereich deutlich verbessert wird. Dies bedeutet, dass die Temperaturüberwachung dynamischer und verzögerungsfreier wird und somit eine schnellere Reaktion auf den Temperaturzustand der elektrischen Maschine beziehungsweise des Wickelkopfs der elektrischen Maschine ermöglicht wird. Eine entsprechende Überwachung und Steuerung der elektrischen Maschine kann letztlich für eine verbesserte Auslastung der elektrischen Maschine oder einen ökonomischeren, d.h. Energie sparenden, Betrieb derselben genutzt werden.

Vorzugsweise kann das erfindungsgemäße Verfahren auch derart ausgestaltet sein, dass als zweiter Wellenlängenbereich ein Bereich außerhalb des Wellenlängenbereichs der Absorptionsbande des Ionisationsproduktes verwendet wird. Dies bietet den Vorteil, dass die Messung der Strahlungsintensität in dem Wellenlängenbereich der Absorptionsbande und die Messung der Strahlungsintensität in dem zweiten Wellenlängenbereich völlig unabhängig voneinander sind. Im Falle der Verwendung von Ozon als Ionisationsprodukt kann der zweite Wellenlängenbereich beispielsweise im Bereich zwischen 3,5 und 4µm gewählt werden, da hier keine Absorptionsbanden des Ozons liegen. Der Wellenlängenbereich der Absorptionsbande könnte beispielsweise wiederum im Bereich von 9,6µm, d.h. im Bereich der Hauptbande des Ozons, gewählt werden. Grundsätzlich ist es jedoch auch möglich, den zweiten Wellenlängenbereich breitbandig, d.h. nicht spektralselektiv, zu wählen. Des Weiteren kann der zweite Wellenlängenbereich besonders vorteilhaft auch mittels eines auch als "Notch-Filter" bezeichneten Kerbfilters realisiert werden. Dies bedeutet, dass in dem zweiten Wellenlängenbereich im Wesentlichen gerade der Wellenlängenbereich der Absorptionsbande des Ionisationsproduktes ausgenommen wird.

In in der vorliegenden Ausführungsform der Erfindung läuft das erfindungsgemäße Verfahren so ab, dass zum Ermitteln der zumindest einen Kenngröße für die Teilentladungsaktivität innerhalb der elektrischen Maschine das Verhältnis zwischen der in dem zweiten Wellenlängenbereich gemessenen Strahlungsintensität und der in dem Wellenlängenbereich der Absorptionsbande gemessenen Strahlungsintensität gebildet wird. Dies ist vorteilhaft, da die in dem zweiten Wellenlängenbereich gemessene Strahlungsintensität, die zur Bestimmung der Temperatur verwendet wird, gleichzeitig auch für eine Normierung der in dem Wellenlängenbereich der Absorptionsbande des Ionisationsproduktes gemessenen Strahlungsintensität verwendet werden kann. Durch das Bilden des Verhältnisses zwischen der in dem zweiten Wellenlängenbereich gemessenen Strahlungsintensität und der im dem Wellenlängenbereich der Absorptionsbande gemessenen Strahlungsintensität wird somit die Temperaturabhängigkeit der Strahlungsintensität berücksichtigt, so dass eine quantitativ genauere Messung ermöglicht wird.

Vorteilhafterweise kann das erfindungsgemäße Verfahren auch derart weitergebildet sein, dass als Kenngröße für die Teilentladungsaktivität innerhalb der elektrischen Maschine aus der in dem Wellenlängenbereich der Absorptionsbande gemessenen Strahlungsintensität die Anzahl, die Häufigkeit und/oder die Intensität von bei Teilentladungen auftretenden Intensitätsspitzen der Emission ermittelt werden. Hierbei wird unter der Häufigkeit die Anzahl von Teilentladungen innerhalb eines definierten Zeitraums verstanden. Gemäß dem Kirchhoffschen Strahlungsgesetz erfolgt Emission genau für die Wellenlängen beziehungsweise Wellenlängenbereiche, in denen auch eine Absorption stattfindet. Dies hat zur Folge, dass bei dem Auftreten einer Teilentladung und der damit verbundenen Entstehung von Ozon in dem Wellenlängenbereich der Absorptionsbande des Ionisationsproduktes Intensitätsspitzen der Emission, d.h. Maxima der gemessenen Strahlungsintensität, entstehen. Da diese Intensitätsspitzen aufgrund der hohen Energiedichte bei oder zumindest zeitnah zu einer Teilentladung auftreten, stellen sie ein Maß für die Anzahl beziehungsweise Häufigkeit von Teilentladungen dar. Dies bedeutet, dass eine Registrierung der Spitzen der gemessenen Strahlungsintensität eine Aussage über die Häufigkeit von Teilentladungen ermöglicht. In Verbindung mit einer zugehörigen Auswerteelektronik oder einer entsprechenden Software kann somit als Kenngröße für die Teilentladungsaktivität innerhalb der elektrischen Maschine beispielsweise ein Zählen oder Aufintegrieren der Intensitätsspitzen erfolgen, so dass etwa eine Auswertung der Intensität der Teilentladungen erfolgen kann. Eine entsprechende Messung kann dabei alternativ oder zusätzlich zu einer Bestimmung der Konzentration des Ionisationsproduktes basierend auf der außerhalb der Teilentladungen, d.h. außerhalb der Intensitätsspitzen, dominierenden Absorption erfolgen. Generell bietet sich eine Auswertung von bei Teilentladungen auftretenden Intensitätsspitzen der Emission insbesondere bei der Verwendung von Ozon als Ionisationsprodukt an, da bei einer entsprechenden äußeren Teilentladung, das heißt in der Ionisationsstrecke, die lokal höchste Temperatur vorliegt. Im Unterschied zur Verwendung eines Ionisationsproduktes eines Isolierstoffes eines Isolators liegt hierbei vorteilhafterweise keine beziehungsweise lediglich eine schwache thermische Anbindung vor.

Vorteilhafterweise kann das erfindungsgemäße Verfahren auch derart ausgeprägt sein, dass die Strahlungsintensität durch den Infrarot-Sensor selektiv in zumindest einem weiteren Wellenlängenbereich zumindest einer weiteren Absorptionsbande desselben Ionisationsproduktes gemessen wird. Dies bietet den Vorteil, dass anhand der zusätzlichen Messung in dem zumindest einen weiteren Wellenlängenbereich eine Erhöhung der Genauigkeit der ermittelten zumindest einen Kenngröße für die Teilentladungsaktivität ermöglicht wird. Darüber hinaus besteht gegebenenfalls die Möglichkeit, die zusätzliche Messung im Rahmen einer Kalibrierung des Infrarot-Sensors zu verwenden.

Vorteilhafterweise kann das erfindungsgemäße Verfahren auch derart ausgeführt sein, dass eine Referenz-Strahlungsintensität in dem Wellenlängenbereich der Absorptionsbande in einem Zustand ohne Teilentladungen erfasst und zur Kalibrierung des Infrarot-Sensors verwendet wird. Dies bietet den Vorteil, dass Änderungen der Eigenschaften des Infrarot-Sensors, etwa aufgrund von Alterung oder Verschmutzung, mittels einer Kalibrierung anhand der erfassten Referenz-Strahlungsintensität korrigiert werden können.

Vorteilhafterweise kann das erfindungsgemäße Verfahren auch derart ausgestaltet sein, dass zum Kalibrieren des Infrarot-Sensors ein Emitter bekannter Strahlungsintensität verwendet wird. Die Verwendung des Emitters bekannter Strahlungsintensität als Kalibrierstrahler ermöglicht beispielsweise die Nachführung von Sensordriften, die im Dauerbetrieb durch eine Verschmutzung der Optik des Infrarot-Sensors auftreten können. Zu beachten ist hierbei jedoch, dass der Emitter bekannter Strahlungsintensität ausschließlich zum Kalibrieren des Infrarot-Sensors verwendet wird. Dies bedeutet, dass ein entsprechender Emitter auch im Rahmen der beschriebenen bevorzugten Ausführungsform des erfindungsgemäßen Verfahrens bei der eigentlichen Überwachung des Betriebszustands der elektrischen Maschine nicht eingesetzt wird.

Die Erfindung betrifft des Weiteren eine Anordnung mit einer elektrischen Maschine.

Hinsichtlich der Anordnung liegt der vorliegenden Erfindung die Aufgabe zugrunde, eine Anordnung mit einer elektrischen Maschine anzugeben, die ein besonders einfaches und zugleich leistungsfähiges Verfahren zum Überwachen des Betriebszustands einer elektrischen Maschine unterstützt.

Diese Aufgabe wird erfindungsgemäß gelöst durch eine Anordnung mit einer elektrischen Maschine, einem über eine Luftstrecke auf zumindest einen Bestandteil der elektrischen Maschine ausgerichteten Infrarot-Sensor mit einem ersten Messkanal zum selektiven Messen einer Strahlungsintensität in einem Wellenlängenbereich einer Absorptionsbande eines bei Teilentladungen entstehenden Ionisationsproduktes, insbesondere von bei der Ionisation von Luft entstehenden Ozons, Auswertemitteln zum Ermitteln zumindest einer Kenngröße für die Teilentladungsaktivität innerhalb der elektrischen Maschine als Maß für den Betriebszustand der elektrischen Maschine aus der gemessenen Strahlungsintensität, wobei der Infrarot-Sensor (10) einen zweiten Messkanal zum Messen der Strahlungsintensität in einem zweiten Wellenlängenbereich aufweist und die Auswertemittel zum Ermitteln der Temperatur des zumindest einen Bestandteils der elektrischen Maschine (1) als weiteres Maß für den Betriebszustand der elektrischen Maschine (1) aus der in dem zweiten Wellenlängenbereich gemessenen Strahlungsintensität vorgesehen sind, wobei die Auswertemittel zum Ermitteln der zumindest einen Kenngröße für die Teilentladungsaktivität innerhalb der elektrischen Maschine (1) zum Bilden des Verhältnisses zwischen den in dem ersten Messkanal und in dem zweiten Messkanal gemessenen Strahlungsintensitäten ausgebildet sind.

Die Vorteile der erfindungsgemäßen Anordnung sowie der im Folgenden aufgeführten bevorzugten Weiterbildungen der erfindungsgemäßen Anordnung entsprechen im Wesentlichen denjenigen des erfindungsgemäßen Verfahrens sowie der entsprechenden bevorzugten Weiterbildungen des erfindungsgemäßen Verfahrens, so dass diesbezüglich auf die vorstehenden Ausführungen verwiesen wird.

Vorzugsweise ist die erfindungsgemäße Anordnung derart ausgestaltet, dass die Auswertemittel zum Ermitteln zumindest eines die Konzentration des Ionisationsproduktes kennzeichnenden Absorptionswertes als Kenngröße für die Teilentladungsaktivität innerhalb der elektrischen Maschine aus der in dem ersten Messkanal gemessenen Strahlungsintensität vorgesehen sind.

In der vorliegenden Ausführungsform der Erfindung ist die erfindungsgemäße Anordnung derart ausgebildet, dass der Infrarot-Sensor einen zweiten Messkanal zum Messen der Strahlungsintensität in einem zweiten Wellenlängenbereich aufweist und die Auswertemittel zum Ermitteln der Temperatur des zumindest einen Bestandteils der elektrischen Maschine als weiteres Maß für den Betriebszustand der elektrischen Maschine aus der in dem zweiten Wellenlängenbereich gemessenen Strahlungsintensität vorgesehen sind.

Vorzugsweise kann die erfindungsgemäße Anordnung auch derart ausgestaltet sein, dass der zweite Messkanal zum Messen der Strahlungsintensität in einem zweiten Wellenlängenbereich außerhalb des Wellenlängenbereichs der Absorptionsbande des Ionisationsproduktes ausgebildet ist.

In der vorliegenden Ausführungsform der Erfindung ist die erfindungsgemäße Anordnung derart ausgestaltet, dass die Auswertemittel zum Ermitteln der zumindest einen Kenngröße für die Teilentladungsaktivität innerhalb der elektrischen Maschine zum Bilden des Verhältnisses zwischen den in dem ersten Mess-kanal und in dem zweiten Messkanal gemessenen Strahlungsintensitäten ausgebildet sind.

Vorteilhafterweise kann die Erfindung auch derart ausgestaltet sein, dass die Auswertemittel zum Ermitteln der Anzahl, der Häufigkeit und/oder der Intensität von bei Teilentladungen auftretenden Intensitätsspitzen der Emission als Kenngröße für die Teilentladungsaktivität innerhalb der elektrischen Maschine aus der in dem ersten Messkanal gemessenen Strahlungsintensität vorgesehen sind.

In einer weiteren besonders bevorzugten Ausführungsform ist die erfindungsgemäße Anordnung derart weitergebildet, dass der Infrarot-Sensor zumindest einen weiteren Messkanal zum selektiven Messen der Strahlungsintensität in zumindest einem weiteren Wellenlängenbereich zumindest einer weiteren Absorptionsbande desselben Ionisationsproduktes aufweist.

In einer weiteren besonders bevorzugten Ausführungsform ist die erfindungsgemäße Anordnung zum Erfassen einer Referenz-Strahlungsintensität in dem ersten Messkanal in einem Zustand ohne Teilentladungen und zum Kalibrieren des Infrarot-Sensors unter Verwendung der Referenz-Strahlungsintensität ausgebildet.

Vorzugsweise kann die erfindungsgemäße Anordnung auch derart ausgestaltet sein, dass sie einen Emitter bekannter Strahlungsintensität zum Kalibrieren des Infrarot-Sensors aufweist.

Die Erfindung betrifft darüber hinaus einen Infrarot-Sensor.

Hinsichtlich des Infrarot-Sensors liegt der vorliegenden Erfindung die Aufgabe zugrunde, einen Infrarot-Sensor anzugeben, der ein einfaches und zugleich besonders leistungsfähiges Verfahren zum Überwachen des Betriebszustands einer elektrischen Maschine unterstützt.

Diese Aufgabe wird erfindungsgemäß gelöst durch einen Infrarot-Sensor mit einem ersten Messkanal zum selektiven Messen einer Strahlungsintensität in einem Wellenlängenbereich einer Absorptionsbande eines bei Teilentladungen entstehenden Ionisationsproduktes, insbesondere von bei der Ionisation von Luft entstehenden Ozons, einem zweiten Messkanal zum Messen der Strahlungsintensität in einem weiteren Wellenlängenbereich und Auswertemitteln zum Ermitteln einer Temperatur aus der in dem weiteren Wellenlängenbereich gemessenen Strahlungsintensität, wobei die Auswertemittel zum Bilden des Verhältnisses zwischen den in dem ersten Messkanal und in dem zweiten Messkanal gemessenen Strahlungsintensitäten ausgebildet sind.

Hinsichtlich der Vorteil des erfindungsgemäßen Infrarot-Sensors sowie der im Folgenden genannten bevorzugten Weiterbildungen des erfindungsgemäßen Infrarot-Sensors sei wiederum auf die vorstehenden Ausführungen im Zusammenhang mit dem erfindungsgemäßen Verfahren sowie den entsprechenden bevorzugten Weiterbildung des erfindungsgemäßen Verfahrens verwiesen.

Vorzugsweise ist der erfindungsgemäße Infrarot-Sensor derart weitergebildet, dass der zweite Messkanal zum Messen der Strahlungsintensität in einem zweiten Wellenlängenbereich außerhalb des Wellenlängenbereichs der Absorptionsbande des Ionisationsproduktes ausgebildet ist.

In einer weiteren besonders bevorzugten Ausführungsform des erfindungsgemäßen Infrarot-Sensors sind die Auswertemittel zum Ermitteln zumindest eines die Konzentration des jeweiligen Ionisationsproduktes kennzeichnenden Absorptionswertes aus der aus dem ersten Messkanal gemessenen Strahlungsintensität vorgesehen.

Der erfindungsgemäße Infrarot-Sensor ist derart ausgeführt, dass die Auswertemittel zum Bilden des Verhältnisses zwischen den in dem ersten Messkanal und in dem zweiten Messkanal gemessenen Strahlungsintensitäten ausgebildet sind.

In einer weiteren besonders bevorzugten Weiterbildung des erfindungsgemäßen Infrarot-Sensors sind die Auswertemittel zum Ermitteln von Intensitätsspitzen der Emission aus der aus dem ersten Messkanal gemessenen Strahlungsintensität vorgesehen.

Vorzugsweise kann der erfindungsgemäße Infrarot-Sensor auch derart ausgestaltet sein, dass der Infrarot-Sensor zumindest einen weiteren Messkanal zum selektiven Messen der Strahlungsintensität in zumindest einem weiteren Wellenlängenbereich zumindest einer weiteren Absorptionsbande desselben Ionisationsproduktes aufweist.

Vorzugsweise kann der erfindungsgemäße Infrarot-Sensor auch derart weitergebildet sein, dass er zum Erfassen einer Referenz-Strahlungsintensität in dem ersten Messkanal und zur Selbstkalibrierung unter Verwendung der Referenz-Strahlungsintensität ausgebildet ist.

Im Folgenden wird die Erfindung anhand von Ausführungsbeispielen näher erläutert. Hierzu zeigt die
- Figur: in einer schematischen Darstellung in einem Längsschnitt einen Ausschnitt eines Ausfüh- rungsbeispiels der erfindungsgemäßen Anordnung.

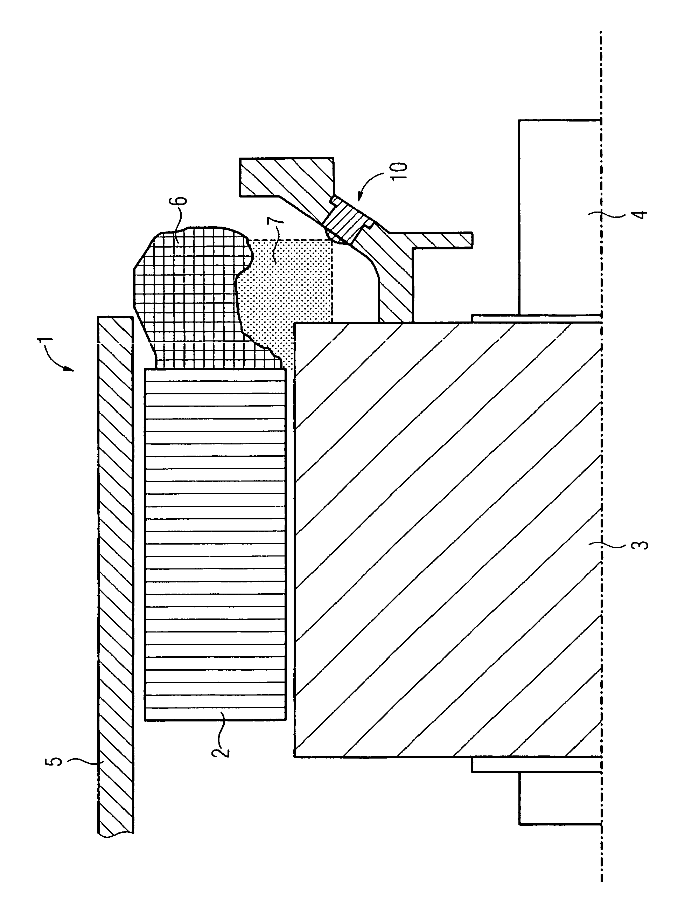

Die Figur zeigt eine elektrische Maschine 1, bei der es sich im Rahmen des beschriebenen Ausführungsbeispiels um einen Elektromotor handeln soll. Die elektrische Maschine 1 weist einen Stator 2 sowie einen Rotor 3 auf. Dabei ist der Rotor 3 zur Rotation um eine Welle 4 der elektrischen Maschine 1 vorgesehen.

Neben den bereits genannten Bestandteilen weist die elektrische Maschine 1 ein Gehäuse 5 sowie einen Wickelkopf 6 auf. Es sei darauf hingewiesen, dass die schematische Darstellung der Figur und der dargestellte Ausschnitt des Aufbaus einer elektrischen Maschine sich auf die für die Beschreibung des Ausführungsbeispiels der Erfindung relevanten Bestandteile konzentriert. Dies bedeutet, dass eine elektrische Maschine in der Praxis eine Vielzahl weiterer Komponenten aufweist, die dem Fachmann jedoch als solche bekannt sind, so dass auf eine detaillierte Beschreibung an dieser Stelle verzichtet wird.

Um den Betriebszustand der elektrischen Maschine 1 ermitteln und überwachen können, weist die dargestellte Anordnung beziehungsweise die elektrische Maschine 1 darüber hinaus einen Infrarot-Sensor 10 auf. Dieser ist beabstandet von dem Wickelkopf 6 der elektrischen Maschine 1 angeordnet, wobei der Infrarot-Sensor 10 über eine Luftstrecke auf den Wickelkopf 6 ausgerichtet ist. Aufgrund von Reflexionen an den metallischen Oberflächen des Wickelkopfs 6, des Stators 2 sowie des Rotors 3 ergibt sich hierbei ein von dem Infrarot-Sensor 10 zumindest mittelbar erfasstes Messvolumen 7 entsprechend der Darstellung in der Figur.

Um eine Aussage über im Betrieb der elektrischen Maschine 1 auftretende Teilentladungen und damit über den Betriebszustand der elektrischen Maschine 1 zu ermöglichen, dient der Infrarot-Sensor 10 dem Nachweis eines bei der Ionisation von Luft entstehenden Ionisationsproduktes. Dabei sei im vorliegenden Ausführungsbeispiel angenommen, dass als Ionisationsprodukt Ozon verwendet wird, d.h. als indirekter Nachweis für Teilentladungen das bei den Teilentladungen entstehende Ozon nachgewiesen wird. Dieses Ozon befindet sich auch in dem Messvolumen 7, so dass die Intensität der von dem Wickelkopf 6 sowie dem Stator 2 und dem Rotor 3 aufgrund ihrer Temperatur abgegebenen Strahlung in Wellenlängenbereichen von Absorptionsbanden des Ozons abgeschwächt wird. Dabei hängt die gemessene Strahlungsintensität gemäß dem Lambert-Beerschen-Gesetz von der Ozonkonzentration in dem Messvolumen 7 ab. Hierbei ist zu berücksichtigen, dass aufgrund von Mehrfachreflexionen an den metallischen Oberflächen insbesondere des Wickelkopfs 6, des Stators 2 sowie des Rotors 3 der elektrischen Maschine 1 die effektive Weglänge der Strahlung auf dem Weg zu dem Infrarot-Sensor 10 im Mittel größer ist als die eigentliche räumliche Entfernung. Hierdurch wird vorteilhafterweise die Nachweisempfindlichkeit der Anordnung beziehungsweise des Verfahrens verbessert.

Es sei angenommen, dass der Infrarot-Sensor 10 einen ersten Messkanal zum selektiven Messen der Strahlungsintensität in einem Wellenlängenbereich der Absorptionsbande des Ozons bei 9,6µm aufweist. Alternativ hierzu könnten jedoch auch andere Absorptionsbanden des Ozons verwendet werden. Aus der mittels des ersten Messkanals gemessenen Strahlungsintensität kann nun zumindest eine Kenngröße für die Teilentladungsaktivität innerhalb der elektrischen Maschine 1 als Maß für den Betriebszustand der elektrischen Maschine 1 ermittelt werden. Bei der Kenngröße für die Teilentladungsaktivität kann es sich insbesondere um einen oder mehrere die Konzentration des Ozons kennzeichnende Absorptionswerte handeln. Dies bedeutet, dass aus der gemessenen Strahlungsintensität, d.h. aus der Stärke der Absorption, auf die Konzentration des Ozons in dem Messvolumen 7 der elektrischen Maschine 1 geschlossen werden kann. Um die Messgenauigkeit zu erhöhen und eine genaue quantitative Bestimmung zu ermöglichen, können hierbei vorteilhafterweise Referenzmessungen verwendet werden.

Eine solche Referenzmessung kann einerseits derart erfolgen, dass der Infrarot-Sensor 10 einen zweiten Messkanal zum Messen der Strahlungsintensität in einem zweiten Wellenlängenbereich aufweist. Dabei liegt der zweite Wellenlängenbereich vorzugsweise außerhalb der verwendeten Absorptionsbande des Ozons. Mittels Auswertemitteln, etwa in Form eines Mikroprozessors, die Bestandteil des Infrarot-Sensors sein können oder als separate Komponente ausgeführt sein können, kann einerseits die Temperatur des zumindest einen Bestandteils der elektrischen Maschine 1, d.h. insbesondere des Wickelkopfs 6, ermittelt werden. Vorteilhafterweise stellt die Temperatur hierbei ein weiteres Maß für den Betriebszustand der elektrischen Maschine dar. Darüber hinaus kann die in dem zweiten Messkanal gemessene Strahlungsintensität zur Normierung beziehungsweise Kalibrierung der in dem ersten Messkanal, d.h. im Wellenlängenbereich der Absorptionsbande des Ozons, gemessenen Strahlungsintensität verwendet werden. Dies bietet insbesondere den Vorteil, dass auch eine quantitativ genaue Ermittlung der Ozonkonzentration ermöglicht wird.

Neben einer Messung der Konzentration des Ozons anhand der gemäß dem Lambert-Beerschen-Gesetz erfolgenden Abschwächung der Strahlungsintensität, die von dem zumindest einen Bestandteil der elektrischen Maschine abgestrahlt wird, ermöglicht es das in der Figur dargestellte Ausführungsbeispiel der erfindungsgemäßen Anordnung vorteilhafterweise auch, als Kenngröße für die Teilentladungsaktivität innerhalb der elektrischen Maschine 1 aus der in dem Wellenlängenbereich der Absorptionsbande des Ozons gemessenen Strahlungsintensität Intensitätsspitzen der Emission d.h. Maxima der Strahlungsintensität, zu ermitteln, welche die Häufigkeit von Teilentladungen kennzeichnen. Aufgrund des Kirchhoffschen Strahlungsgesetzes wird die bei einer Teilentladung entstehende Energie insbesondere durch Strahlungsemission im Bereich der Absorptionsbande des Ozons umgesetzt. Somit ermöglicht es der Nachweis der Intensitätsspitzen der Emission, die Anzahl von Teilentladungen zu ermitteln. Hierbei handelt es sich somit um eine weitere Kenngröße für die Teilentladungsaktivität innerhalb der elektrischen Maschine 1, die alternativ oder zusätzlich zu einer auf der Absorption beruhenden Konzentrationsbestimmung des Ozons ermittelt werden kann. Der Nachweis der Intensitätsspitzen der Emission weist hierbei insbesondere den Vorteil auf, dass eine Sensitivität in diesem Fall auch dann gegeben ist, wenn die Luft beziehungsweise das Gas in dem Messvolumen 7 eine höhere Temperatur aufweist, als der Wickelkopf 6. Im Unterschied hierzu wäre eine allein auf der Absorption der Strahlung durch bei Teilentladungen entstandenes Ozon basierende Ermittlung des Betriebszustands der elektrischen Maschine 1 in diesem Fall nicht möglich.

Es sei an dieser Stelle nochmals darauf hingewiesen, dass die in der Figur dargestellte Ausführungsform der erfindungsgemäßen Anordnung insbesondere den Vorteil aufweist, dass ein Emitter bekannter Strahlungsintensität zum Ermitteln beziehungsweise Überwachen des Betriebszustandes der elektrischen Maschine 1 vorteilhafterweise nicht verwendet wird. Hierdurch wird die Anordnung deutlich vereinfacht und kostengünstiger. Generell ermöglicht insbesondere die Kombination einer Temperaturmessung mit der Messung einer Kenngröße für die Teilentladungsaktivität, eine besonders aussagekräftige und zugleich vergleichsweise kostengünstige Überwachung des Betriebszustands der elektrischen Maschine 1 vorzunehmen. Dabei kann das erfindungsgemäße Verfahren sowie seine bevorzugten Weiterbildungen in elektrischen Maschinen beliebiger Art, Größe und Leistung eingesetzt werden.

## Patentansprüche

1. Verfahren zum überwachen des Betriebszustands einer elektrischen Maschine (1), bei dem
- durch einen über eine Luftstrecke auf zumindest einen Bestandteil der elektrischen Maschine (1) ausgerichteten Infrarot-Sensor (10) selektiv in einem Wellenlängenbereich einer Absorptionsbande eines bei Teilentladungen entstehenden Ionisationsproduktes, insbesondere von bei der Ionisation von Luft entstehenden Ozons, eine Strahlungsintensität gemessen wird,
- aus der gemessenen Strahlungsintensität zumindest eine Kenngröße für die Teilentladungsaktivität innerhalb der elektrischen Maschine (1) als Maß für den Betriebszustand der elektrischen Maschine (1) ermittelt wird,
- die Strahlungsintensität durch den Infrarot-Sensor (10) zusätzlich in einem zweiten Wellenlängenbereich gemessen wird und
- aus der in dem zweiten Wellenlängenbereich gemessenen Strahlungsintensität die Temperatur des zumindest einen Bestandteils der elektrischen Maschine (1) als weiteres Maß für den Betriebszustand der elektrischen Maschine (1) ermittelt wird
**dadurch gekennzeichnet, dass** zum Ermitteln der zumindest einen Kenngröße für die Teilentladungsaktivität innerhalb der elektrischen Maschine (1) das Verhältnis zwischen der in dem zweiten Wellenlängenbereich gemessenen Strahlungsintensität und der in dem Wellenlängenbereich der Absorptionsbande gemessenen Strahlungsintensität gebildet wird.

2. Verfahren nach Anspruch 1,
**dadurch gekennzeichnet, dass** als Kenngröße für die Teilentladungsaktivität innerhalb der elektrischen Maschine (1) aus der gemessenen Strahlungsintensität zumindest ein die Konzentration des Ionisationsproduktes kennzeichnender Absorptionswert ermittelt wird.

3. Verfahren nach Anspruch 1 oder 2,
**dadurch gekennzeichnete, dass** als zweiter Wellenlängenbereich ein Bereich außerhalb des Wellenlängenbereichs der Absorptionsbande des Ionisationsproduktes verwendet wird.

4. Verfahren nach einem der vorangehenden Ansprüche,
**dadurch gekennzeichnet, dass** als Kenngröße für die Teilentladungsaktivität innerhalb der elektrischen Maschine (1) aus der in dem Wellenlängenbereich der Absorptionsbande gemessenen Strahlungsintensität die Anzahl, die Häufigkeit und/oder die Intensität von bei Teilentladungen auftretenden Intensitätsspitzen der Emission ermittelt werden.

5. Verfahren nach einem der vorangehenden Ansprüche,
**dadurch gekennzeichnet, dass** die Strahlungsintensität durch den Infrarot-Sensor (10) selektiv in zumindest einem weiteren Wellenlängenbereich zumindest einer weiteren Absorptionsbande desselben Ionisationsproduktes gemessen wird.

6. Verfahren nach einem der vorangehenden Ansprüche,
**dadurch gekennzeichnet, dass** eine Referenz-Strahlungsintensität in dem Wellenlängenbereich der Absorptionsbande in einem Zustand ohne Teilentladungen erfasst und zur Kalibrierung des Infrarot-Sensors (10) verwendet wird.

7. Verfahren nach einem der vorangehenden Ansprüche,
**dadurch gekennzeichnet, dass** zum Kalibrieren des Infrarot-Sensors (10) ein Emitter bekannter Strahlungsintensität verwendet wird.

8. Anordnung mit
- einer elektrischen Maschine (1),
- einem über eine Luftstrecke auf zumindest einen Bestandteil der elektrischen Maschine ausgerichteten Infrarot-Sensor (10) mit einem ersten Messkanal zum selektiven Messen einer Strahlungsintensität in einem Wellenlängenbereich einer Absorptionsbande eines bei Teilentladungen entstehenden Ionisationsproduktes, insbesondere von bei der Ionisation von Luft entstehenden Ozons,
- Auswertemitteln zum Ermitteln zumindest einer Kenngröße für die Teilentladungsaktivität innerhalb der elektrischen Maschine (1) als Maß für den Betriebszustand der elektrischen Maschine (1) aus der gemessenen Strahlungsintensität,
- der Infrarot-Sensor (10) einen zweiten Messkanal zum Messen der Strahlungsintensität in einem zweiten Wellenlängenbereich aufweist und
- die Auswertemittel zum Ermitteln der Temperatur des zumindest einen Bestandteils der elektrischen Maschine (1) als weiteres Maß für den Betriebszustand der elektrischen Maschine (1) aus der in dem zweiten Wellenlängenbereich gemessenen Strahlungsintensität vorgesehen sind
**dadurch gekennzeichnet, dass** die Auswertemittel zum Ermitteln der zumindest einen Kenngröße für die Teilentladungsaktivität innerhalb der elektrischen Maschine (1) zum Bilden des Verhältnisses zwischen den in dem ersten Messkanal und in dem zweiten Messkanal gemessenen Strahlungsintensitäten ausgebildet sind.

9. Anordnung nach Anspruch 8,
**dadurch gekennzeichnet, dass** die Auswertemittel zum Ermitteln zumindest eines die Konzentration des Ionisationsproduktes kennzeichnenden Absorptionswertes als Kenngröße für die Teilentladungsaktivität innerhalb der elektrischen Maschine (1) aus der in dem ersten Messkanal gemessenen Strahlungsintensität vorgesehen sind.

10. Anordnung nach Anspruch 8,
**dadurch gekennzeichnet, dass** der zweite Messkanal zum Messen der Strahlungsintensität in einem zweiten Wellenlängenbereich außerhalb des Wellenlängenbereichs der Absorptionsbande des Ionisationsproduktes ausgebildet ist.

11. Anordnung nach einem der Ansprüche 8 bis 10,
**dadurch gekennzeichnet, dass** die Auswertemittel zum Ermitteln der Anzahl, der Häufigkeit und/oder der Intensität von bei Teilentladungen auftretenden Intensitätsspitzen der Emission als Kenngröße für die Teilentladungsaktivität innerhalb der elektrischen Maschine (1) aus der in dem ersten Messkanal gemessenen Strahlungsintensität vorgesehen sind.

12. Anordnung nach einem der Ansprüche 8 bis 11,
**dadurch gekennzeichnet, dass** der Infrarot-Sensor (10) zumindest einen weiteren Messkanal zum selektiven Messen der Strahlungsintensität in zumindest einem weiteren Wellenlängenbereich zumindest einer weiteren Absorptionsbande desselben Ionisationsproduktes aufweist.

13. Anordnung nach einem der Ansprüche 8 bis 12,
**dadurch gekennzeichnet, dass** die Anordnung zum Erfassen einer Referenz-Strahlungsintensität in dem ersten Messkanal in einem Zustand ohne Teilentladungen und zum Kalibrieren des Infrarot-Sensors (10) unter Verwendung der Referenz-Strahlungsintensität ausgebildet ist.

14. Anordnung nach einem der Ansprüche 8 bis 13,
**dadurch gekennzeichnet, dass** sie einen Emitter bekannter Strahlungsintensität zum Kalibrieren des Infrarot-Sensors (10) aufweist.

15. Infrarot-Sensor (10) mit
- einem ersten Messkanal zum selektiven Messen einer Strahlungsintensität in einem Wellenlängenbereich einer Absorptionsbande eines bei Teilentladungen entstehenden Ionisationsproduktes, insbesondere von bei der Ionisation von Luft entstehenden Ozons,
- einem zweiten Messkanal zum Messen der Strahlungsintensität in einem weiteren Wellenlängenbereich und
- Auswertemitteln zum Ermitteln einer Temperatur aus der in dem weiteren Wellenlängenbereich gemessenen Strahlungsintensität
**dadurch gekennzeichnet, dass** die Auswertemittel zum Bilden des Verhältnisses zwischen den in dem ersten Messkanal und in dem zweiten Messkanal gemessenen Strahlungsintensitäten ausgebildet sind.

16. Infrarot-Sensor nach Anspruch 15,
**dadurch gekennzeichnet, dass** der zweite Messkanal zum Messen der Strahlungsintensität in einem zweiten Wellenlängenbereich außerhalb des Wellenlängenbereichs der Absorptionsbande des Ionisationsproduktes ausgebildet ist.

17. Infrarot-Sensor nach Anspruch 15 oder 16,
**dadurch gekennzeichnet, dass** die Auswertemittel zum Ermitteln zumindest eines die Konzentration des Ionisationsproduktes kennzeichnenden Absorptionswertes aus der in dem ersten Messkanal gemessenen Strahlungsintensität vorgesehen sind.

18. Infrarot-Sensor nach einem der Ansprüche 15 bis 17,
**dadurch gekennzeichnet, dass** die Auswertemittel zum Ermitteln von Intensitätsspitzen der Emission aus der in dem ersten Messkanal gemessenen Strahlungsintensität vorgesehen sind.

19. Infrarot-Sensor nach einem der Ansprüche 15 bis 18,
**dadurch gekennzeichnet, dass** der Infrarot-Sensor (10) zumindest einen weiteren Messkanal zum selektiven Messen der Strahlungsintensität in zumindest einem weiteren Wellenlängenbereich zumindest einer weiteren Absorptionsbande desselben Ionisationsproduktes aufweist.

20. Infrarot-Sensor nach einem der Ansprüche 15 bis 19,
**dadurch gekennzeichnet, dass** er zum Erfassen einer Referenz-Strahlungsintensität in dem ersten Messkanal und zur Selbstkalibrierung unter Verwendung der Referenz-Strahlungsintensität ausgebildet ist.

## Claims

1. Method for monitoring the operating state of an electric machine (1), wherein
- a radiation intensity is measured selectively in a wavelength range of an absorption band of an ionisation product arising from partial discharges, particularly of ozone arising from the ionisation of air, by an infrared sensor (10) aligned to at least one part of the electric machine (1) across an air gap,
- at least one parameter for the partial discharge activity within the electric machine (1) is determined from the measured radiation intensity as a measure of the operating state of the electric machine (1),
- the radiation intensity is additionally measured by the infrared sensor (10) in a second wavelength range and
- the temperature of the at least one part of the electric machine (1) is determined from the radiation intensity measured in the second wavelength range as a further measure of the operating state of the electric machine (1),
**characterised in that**
the ratio between the radiation intensity measured in the second wavelength range and the radiation intensity measured in the wavelength range of the absorption band is formed in order to determine the at least one parameter for the partial discharge activity within the electric machine (1).

2. Method according to claim 1,
**characterised in that**
at least one absorption value characterising the concentration of the ionisation product is determined from the measured radiation intensity as a parameter for the partial discharge activity within the electric machine (1).

3. Method according to claim 1 or 2,
**characterised in that**
a range outside the wavelength range of the absorption band of the ionisation product is used as a second wavelength range.

4. Method according to one of the preceding claims,
**characterised in that**
the number, the frequency and/or the intensity of intensity peaks of the emission arising from partial discharges are determined from the radiation intensity measured in the wavelength range of the absorption band as a parameter for the partial discharge activity within the electric machine (1).

5. Method according to one of the preceding claims,
**characterised in that**
the radiation intensity is measured selectively by the infrared sensor (10) in at least one further wavelength range of at least one further absorption band of the same ionisation product.

6. Method according to one of the preceding claims,
**characterised in that**
a reference radiation intensity is recorded in the wavelength range of the absorption band in a state without partial discharges and is used for calibrating the infrared sensor (10) .

7. Method according to one of the preceding claims,
**characterised in that**
an emitter of known radiation intensity is used for calibrating the infrared sensor (10).

8. Arrangement having
- an electric machine (1),
- an infrared sensor (10) aligned to at least one part of the electric machine (1) across an air gap with a first measurement channel for selectively measuring a radiation intensity in a wavelength range of an absorption band of an ionisation product arising from partial discharges, particularly of ozone arising from the ionisation of air,
- evaluation means for determining at least one parameter for the partial discharge activity within the electric machine (1) from the measured radiation intensity as a measure of the operating state of the electric machine (1),
- the infrared sensor (10) has a second measurement channel for measuring the radiation intensity in a second wavelength range and
- the evaluation means are provided for determining the temperature of the at least one part of the electric machine (1) from the radiation intensity measured in the second wavelength range as a further measure of the operating state of the electric machine (1),
**characterised in that**
the evaluation means are designed for determining the at least one parameter for the partial discharge activity within the electric machine (1) in order to form the ratio between the radiation intensities measured in the first measurement channel and in the second measurement channel.

9. Arrangement according to claim 8,
**characterised in that**
the evaluation means are provided for determining at least one absorption value characterising the concentration of the ionisation product from the radiation intensity measured in the first measurement channel as a parameter for the partial discharge activity within the electric machine (1).

10. Arrangement according to claim 8,
**characterised in that**
the second measurement channel is designed for measuring the radiation intensity in a second wavelength range outside the wavelength range of the absorption band of the ionisation product.

11. Arrangement according to one of claims 8 to 10,
**characterised in that**
the evaluation means are provided for determining the number, the frequency and/or the intensity of intensity peaks of the emission arising from partial discharges from the radiation intensity measured in the first measurement channel as a parameter for the partial discharge activity within the electric machine (1).

12. Arrangement according to one of claims 8 to 11,
**characterised in that**
the infrared sensor (10) has at least one further measurement channel for selectively measuring the radiation intensity in at least one further wavelength range of at least one further absorption band of the same ionisation product.

13. Arrangement according to one of claims 8 to 12,
**characterised in that**
the arrangement is designed for recording a reference radiation intensity in the first measurement channel in a state without partial discharges and for calibrating the infrared sensor (10) using the reference radiation intensity.

14. Arrangement according to one of claims 8 to 13,
**characterised in that**
it has an emitter of known radiation intensity for calibrating the infrared sensor (10).

15. Infrared sensor (10) having
- a first measurement channel for selectively measuring a radiation intensity in a wavelength range of an absorption band of an ionisation product arising from partial discharges, particularly of ozone arising from the ionisation of air,
- a second measurement channel for measuring the radiation intensity in a further wavelength range and
- evaluation means for determining a temperature from the radiation intensity measured in the further wavelength range,
**characterised in that**
the evaluation means are designed for forming the ratio between the radiation intensities measured in the first measurement channel and in the second measurement channel.

16. Infrared sensor according to claim 15,
**characterised in that**
the second measurement channel is designed for measuring the radiation intensity in a second wavelength range outside the wavelength range of the absorption band of the ionisation product.

17. Infrared sensor according to claim 15 or 16,
**characterised in that**
the evaluation means are provided for determining at least one absorption value characterising the concentration of the ionisation product from the radiation intensity measured in the first measurement channel.

18. Infrared sensor according to one of claims 15 to 17,
**characterised in that**
the evaluation means are provided for determining intensity peaks of the emission from the radiation intensity measured in the first measurement channel.

19. Infrared sensor according to one of claims 15 to 18,
**characterised in that**
the infrared sensor (10) has at least one further measurement channel for selectively measuring the radiation intensity in at least one further wavelength range of at least one further absorption band of the same ionisation product.

20. Infrared sensor according to one of claims 15 to 19,
**characterised in that**
it is designed for recording a reference radiation intensity in the first measurement channel and for self-calibration using the reference radiation intensity.

## Revendications

1. Procédé pour surveiller l'état de fonctionnement d'une machine électrique (1), dans lequel
- une intensité de rayonnement est mesurée par un capteur infrarouge (10) orienté à travers une distance dans l'air sur au moins un composant de la machine électrique (1) de façon sélective dans une plage de longueurs d'onde d'une bande d'absorption d'un produit d'ionisation se formant en cas de décharges partielles, en particulier d'ozone se formant lors de l'ionisation de l'air,
- au moins une grandeur caractéristique pour l'activité de décharge partielle à l'intérieur de la machine électrique (1) étant déterminée à partir de l'intensité de rayonnement mesurée comme référence pour l'état de fonctionnement de la machine électrique (1),
- l'intensité de rayonnement est mesurée par le capteur infrarouge (10) en supplément dans une seconde plage de longueurs d'onde et
- la température du au moins un composant de la machine électrique (1) est déterminée à partir de l'intensité de rayonnement mesurée dans la seconde plage de longueurs d'onde comme autre critère pour l'état de fonctionnement de la machine électrique (1)
**caractérisé en ce que**
le rapport entre l'intensité de rayonnement mesurée dans la seconde plage de longueurs d'onde et l'intensité de rayonnement mesurée dans la plage de longueurs d'onde de la bande d'absorption est formé pour déterminer la au moins une grandeur caractéristique pour l'activité de décharge partielle à l'intérieur de la machine électrique (1).

2. Procédé selon la revendication 1,
**caractérisé en ce qu'**au moins une valeur d'absorption caractérisant la concentration du produit d'ionisation est déterminée comme grandeur caractéristique pour l'activité de décharge partielle à l'intérieur de la machine électrique (1) à partir de l'intensité de rayonnement mesurée.

3. Procédé selon la revendication 1 ou 2,
**caractérisé en ce qu'**une plage située en dehors de la plage de longueurs d'onde de la bande d'absorption du produit d'ionisation est utilisée comme seconde plage de longueurs d'onde.

4. Procédé selon l'une des revendications précédentes,
**caractérisé en ce que** le nombre, la fréquence et/ou l'intensité de pointes d'intensité, apparaissant en cas de décharges partielles, de l'émission sont déterminés comme grandeur caractéristique pour l'activité de décharge partielle à l'intérieur de la machine électrique (1) à partir de l'intensité de rayonnement mesurée dans la plage de longueurs d'onde de la bande d'absorption.

5. Procédé selon l'une des revendications précédentes,
**caractérisé en ce que** l'intensité de rayonnement est mesurée par le capteur infrarouge (10) de façon sélective dans au moins une autre plage de longueurs d'onde d'au moins une autre bande d'absorption du même produit d'ionisation.

6. Procédé selon l'une des revendications précédentes,
**caractérisé en ce qu'**une intensité de rayonnement de référence est enregistrée dans la plage de longueurs d'onde de la bande d'absorption dans un état sans décharges partielles et est utilisée pour le calibrage du capteur infrarouge (10).

7. Procédé selon l'une des revendications précédentes,
**caractérisé en ce qu'**un émetteur d'intensité de rayonnement connue est utilisé pour le calibrage du capteur infrarouge (10).

8. Agencement comprenant
- une machine électrique (1),
- un capteur infrarouge (10) orienté à travers une distance dans l'air sur au moins un composant de la machine électrique et doté d'un premier canal de mesure pour la mesure sélective d'une intensité de rayonnement dans une plage de longueurs d'onde d'une bande d'absorption d'un produit d'ionisation se formant en cas de décharges partielles, en particulier d'ozone se formant lors de l'ionisation de l'air,
- des moyens d'analyse pour déterminer au moins une grandeur caractéristique pour l'activité de décharge partielle à l'intérieur de la machine électrique (1) comme référence pour l'état de fonctionnement de la machine électrique (1) à partir de l'intensité de rayonnement mesurée,
- le capteur infrarouge (10) présentant un second canal de mesur pour mesurer l'intensité de rayonnement dans une seconde plage de longueurs d'onde et
- les moyens d'analyse étant prévus pour déterminer la température du au moins un composant de la machine électrique (1) comme autre référence pour l'état de fonctionnement de la machine électrique (1) à partir de l'intensité de rayonnement mesurée dans la seconde plage de longueurs d'onde,
**caractérisé en ce que** les moyens d'analyse sont conçus pour déterminer la au moins une grandeur caractéristique pour l'activité de décharge partielle à l'intérieur de la machine électrique (1) pour former le rapport entre les intensités de rayonnement mesurées dans le premier canal de mesure et les intensités de rayonnement mesurées dans le second canal de mesure.

9. Agencement selon la revendication 8,
**caractérisé en ce que** les moyens d'analyse sont prévus pour déterminer au moins une valeur d'absorption caractérisant la concentration du produit d'ionisation comme grandeur caractéristique pour l'activité de décharge partielle à l'intérieur de la machine électrique (1) à partir de l'intensité de rayonnement mesurée dans le premier canal de mesure.

10. Agencement selon la revendication 8,
**caractérisé en ce que** le second canal de mesure est conçu pour mesurer l'intensité de rayonnement dans une seconde plage de longueurs d'onde en dehors de la plage de longueurs d'onde de la bande d'absorption du produit d'ionisation.

11. Agencement selon l'une des revendications 8 à 10,
**caractérisé en ce que** les moyens d'analyse sont prévus pour déterminer le nombre, la fréquence et/ou l'intensité de pointes d'intensité, apparaissant en cas des décharges partielles, de l'émission comme grandeur caractéristique pour l'activité de décharge partielle à l'intérieur de la machine électrique (1) à partir de l'intensité de rayonnement mesurée dans le premier canal de mesure.

12. Agencement selon l'une des revendications 8 à 11,
**caractérisé en ce que** le capteur infrarouge (10) présente au moins un autre canal de mesure pour la mesure sélective de l'intensité de rayonnement dans au moins une autre plage de longueurs d'onde d'au moins une autre bande d'absorption du même produit d'ionisation.

13. Agencement selon l'une des revendications 8 à 12,
**caractérisé en ce que** l'agencement est conçu pour l'enregistrement d'une intensité de rayonnement de référence dans le premier canal de mesure est conçu dans un état sans décharges partielles et pour le calibrage du capteur infrarouge (10) avec l'utilisation de l'intensité de rayonnement de référence.

14. Agencement selon l'une des revendications 8 à 13,
**caractérisé en ce qu'**il présente un émetteur d'intensité de rayonnement connu pour le calibrage du capteur infrarouge (10) .

15. Capteur infrarouge (10) comprenant
- un premier canal de mesure pour la mesure sélective d'une intensité de rayonnement dans une plage de longueurs d'onde d'une bande d'absorption d'un produit d'ionisation se formant en cas de décharges partielles, en particulier d'ozone se formant lors de l'ionisation de l'air,
- un second canal de mesure pour mesurer l'intensité de rayonnement dans une autre plage de longueurs d'onde et
- des moyens d'analyse pour déterminer une température à partir de l'intensité de rayonnement mesurée dans l'autre plage de longueurs d'onde,
**caractérisé en ce que**
les moyens d'analyse sont conçus pour former le rapport entre les intensités de rayonnement mesurées dans le premier canal de mesure et mesurées dans le second canal de mesure.

16. Capteur infrarouge selon la revendication 15,
**caractérisé en ce que** le second canal de mesure est conçu pour mesurer l'intensité de rayonnement dans une autre plage de longueurs d'onde en dehors de la plage de longueurs d'onde de la bande d'absorption du produit d'ionisation.

17. Capteur infrarouge selon la revendication 15 ou 16,
**caractérisé en ce que**
les moyens d'analyse sont prévus pour déterminer au moins une valeur d'absorption caractérisant la concentration du produit d'ionisation à partir de l'intensité de rayonnement mesurée dans le premier canal de mesure.

18. Capteur infrarouge selon l'une des revendications 15 à 17,
**caractérisé en ce que**
les moyens d'analyse sont prévus pour déterminer des pointes d'intensité de l'émission à partir de l'intensité de rayonnement mesurée dans le premier canal de mesure.

19. Capteur infrarouge selon l'une des revendications 15 à 18,
**caractérisé en ce que**
le capteur infrarouge (10) présente au moins un autre canal de mesure pour la mesure sélective de l'intensité de rayonnement dans au moins une autre plage de longueurs d'onde d'au moins une autre bande d'absorption du même produit d'ionisation.

20. Capteur infrarouge selon l'une des revendications 15 à 19,
**caractérisé en ce qu'**il est conçu pour l'enregistrement d'une intensité de rayonnement de référence dans le premier canal de mesure et pour l'autocalibrage avec l'utilisation de l'intensité de rayonnement de référence.
